## Europäisches Patentamt

## European Patent Office

## Office européen des brevets

(11) Numéro de publication: **0 077 706**
**B1**

(12) **FASCICULE DE BREVET EUROPEEN**

(45) Date de publication du fascicule du brevet:
**14.05.86**

(21) Numéro de dépôt: **82401821.2**

(22) Date de dépôt: **05.10.82**

(51) Int. Cl.⁴: **H 01 L 29/80,** H 01 L 29/72, H 01 L 29/60

(54) **Transistor à effet de champ à canal vertical.**

(30) Priorité: **16.10.81 FR 8119530**

(43) Date de publication de la demande:
**27.04.83 Bulletin 83/17**

(45) Mention de la délivrance du brevet:
**14.05.86 Bulletin 86/20**

(84) Etats contractants désignés:
**FR**

(56) Documents cités:
**WO - A - 81/00489**
**CH - A - 436 492**
**DE - A - 1 564 068**
**FR - A - 1 317 256**
**FR - A - 2 303 383**
**US - A - 3 381 189**

(73) Titulaire: **THOMSON-CSF, 173, Boulevard Haussmann, F-75379 Paris Cedex 08 (FR)**

(72) Inventeur: **Jay, Paul-Robert, THOMSON-CSF SCPI 173, bld Haussmann, F-75379 Paris Cedex 08 (FR)**
Inventeur: **Rumelhard, Christian, THOMSON-CSF SCPI 173, bld Haussmann, F-75379 Paris Cedex (FR)**

(74) Mandataire: **Lepercque, Jean et al, THOMSON-CSF SCPI 19, avenue de Messine, F-75008 Paris (FR)**

## Description

L'invention concerne un transistor à effet de champ du type à canal vertical désigné dans la littérature anglo-saxonne par le sigle PBT (Permeable Base Transistor) ainsi que le procédé de fabrication de ce transistor.

La demande de brevet WO-A-8100 489 décrit un transistor disposant d'une structure de ce type. La grille d'un tel transistor comprend dans sa partie active une partie en forme de peigne formé de dents parallèles. Un transistor de ce type est formé par la superposition de quatre couches: un substrat de type n fortement dopé, une couche de type n formant la source, un film métallique en forme de peigne et formant la grille, une couche de type n formant le drain. Les régions formant la source et le drain sont entourées par une couche semiconductrice rendue isolante. Les électrons provenant de la région formant la source sont contraints par la présence des zones isolantes de traverser la grille pour arriver au drain. La couche métallique formant la grille du transistor forme un contact Schottky avec le semiconducteur permettant d'assurer le contrôle du passage des électrons entre la source et le drain. La concentration en porteurs est ajustée de telle façon que la largeur de la zone de transition pour une tension de polarisation nulle du contact Schottky est environ le double de l'écart entre les dents du peigne formant la grille. Des revêtements métalliques assurent des contacts ohmiques pour les différentes électrodes.

Par rapport aux transistors à effet de champ classiques, le transistor PBT procure les avantages suivants:

– une structure verticale qui permet un meilleur contrôle des phénomènes internes au transistor,
– le flux d'électrons qui transitent de la source au drain est contrôlé par l'épaisseur de la grille qui a une dimension plus petite que la largeur de la grille dans la technologie planar et qui réduit de ce fait le temps de transit des électrons,
– la possibilité d'une croissance épitaxiale au-dessus de la grille.

Des considérations théoriques prévoient une fréquence maximale d'oscillation d'environ 200 GHz avec des dispositifs de ce type.

Afin d'améliorer ces dispositifs, la présente invention propose de remplacer les moyens de commande du canal de conduction en forme de peigne selon l'art connu par un arrangement de deux jeux de dents parallèles, se croisant pour former une structure en forme de maille afin de créer des filaments de conduction. Cette structure pourra être reliée à une face externe du transistor par n'importe quel côté de sa périphérie.

L'invention a donc pour objet un transistor à effet de champ du type à grille enterrée et à canal vertical comprenant un substrat semi-conducteur monocristallin dopé sur lequel sont épitaxiées successivement plusieurs couches dopées d'un même type de conductivité que ledit substrat; la base du substrat et le sommet de la dernière couche épitaxiée portant respectivement des contacts ohmiques de source et de drain; ledit transistor comportant en outre des moyens conducteurs de commande; la conduction entre source et drain étant distribuée au sein desdites couches épitaxiées et empruntant un faisceau de zones collatérales isolées délimitées par lesdits moyens conducteurs de commande, caractérisé en ce que lesdits moyens conducteurs de commande sont constitués par deux systèmes de barreaux croisés, chaque système étant réuni à un contact d'accès.

Le procédé de fabrication du transistor selon l'invention comporte les mêmes étapes que pour la fabrication des transistors PBT de l'art connu à l'exception de la réalisation de l'électrode de grille pour laquelle la technique utilisée est à faisceau d'électrons et masque ou à balayage électronique.

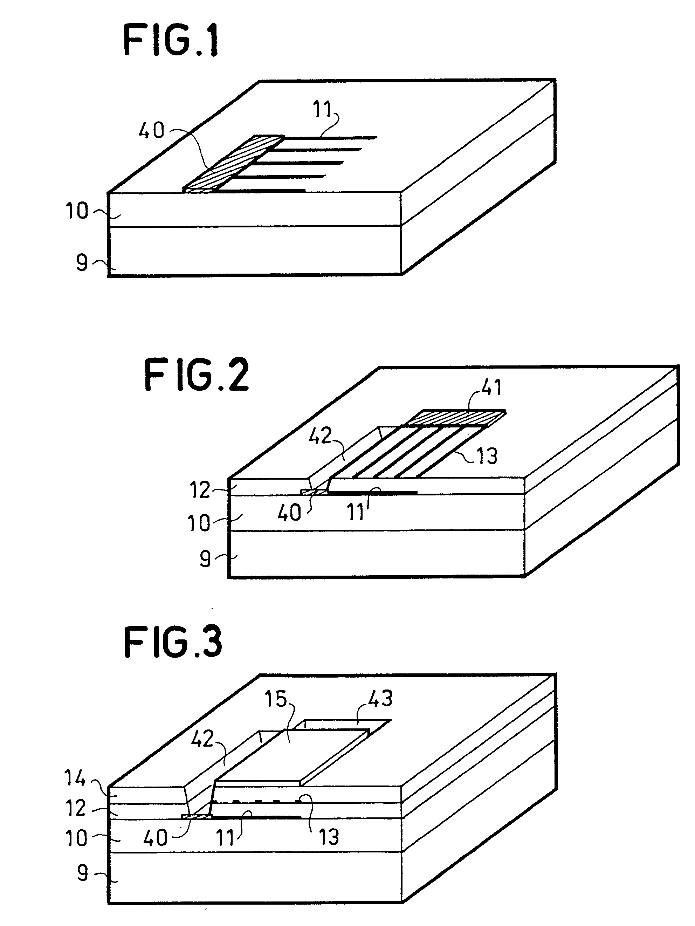

L'invention sera mieux comprise, et d'autres caractéristiques apparaîtront, au moyens de la description qui suit et des dessins qui l'accompagnent parmi lesquels les figures 1 à 5 représentent des étapes du procédé de réalisation d'un transistor bigrille s'inspirant de l'invention.

L'idée maîtresse de l'invention consiste à morceler davantage le canal de conduction reliant la source et le drain afin que le passage des électrons se fasse suivant des filaments conducteurs. A priori cette manière de commander le canal de conduction peut sembler plus complexe que dans l'art connu, cependant des avantages apparaissent qui sont dus à la géométrie du transistor à canal vertical. En effet dans ce type de transistor, on exploite la faible distance existant entre le drain et la source ce qui permet à la croissance épitaxiale de se réaliser dans de bonnes conditions. Cette croissance ne pose pas de problèmes particuliers même dans le cas d'un nombre important de filaments de conduction.

Dans les dispositifs connus de transistors à effet de champ bigrilles tel que celui décrit dans le brevet français FR-A-1 317 256, les deux grilles sont de forme identique et la deuxième est placée dans l'alignement de la première pour les électrons migrant de la source vers le drain. Un gros problème qui se pose alors pour les transistors à canal vertical est de réaliser pratiquement cet alignement avec des grilles enterrées. De même les connexions depuis les électrodes enterrées jusqu'à la surface du transistor posent de sérieux problèmes. Il est possible d'éviter les problèmes qui viennent d'être exposés pour le transistor bigrille en croisant les deux jeux d'électrodes de grille, par exemple orthogonalement.

Les figures 1 à 5 représentent des étapes du procédé de fabrication d'un transistor bigrille utilisant le principe de l'invention.

A titre d'exemple non limitatif la description portera sur un transistor à canal de type n.

Le transistor à effet de champ selon l'invention est du type à canal vertical. Il est réalisé à partir d'un matériau semi-conducteur, par exemple de l'arséniure de gallium (As Ga) monocristallin. Sur un substrat 9 réalisé à partir d'une couche d'arséniure de gallium rendu conducteur de type $n^+$ par l'introduction d'impuretés, on a développé par dépôt épitaxial une couche 10 de type n. Ce dépôt épitaxial peut être réalisé à partir d'un système $As\,Cl_3 - Ga - H_2$ – ou par un procédé organométallique ou encore par jet moléculaire.

En utilisant une résine sensible à un faisceau d'électrons et par un masque on a ensuite réalisé l'électrode de grille 11 sous la forme d'un film métallique de tungstène par exemple. L'avantage que présente le tungstène est d'être suffisamment inerte face à l'arséniure de gallium et aux autres produits utilisés lors de la croissance épitaxiale. L'épaisseur de cette électrode peut être de quelques centaines d'angströms.

L'électrode 11 a la forme d'un peigne et comporte des dents (ou barreaux) parallèles reliées entre elles par une barre transversale 40 qui est plus large et plus épaisse que les dents. On peut aussi relier les dents par une autre barre située à l'opposé de la première par rapport aux dents afin de former un cadre de liaison.

La croissance de l'arséniure de gallium de type n à travers les interstices de l'électrode en tungstène permet de créer une diode par contact Schottky. La transition entre les concentrations de porteurs des deux couches épitaxiales doit être graduelle. L'épaisseur de ces couches est de l'ordre de quelques dixièmes de microns.

Au stade représenté par la figure 2, on a fait croître une autre couche épitaxiale 12 de type n de même dopage que la couche 10 sur laquelle un autre peigne 13 de tungstène a été déposé par la même technique que le premier et orthogonalement à celui-ci. Comme le peigne 11, le peigne 13 est formé de dents parallèles reliées entre elles par au moins une barre transversale 41 plus large et plus épaisse que les dents. On peut voir également la présence de la faille 42 dans la couche 12 due aux dimensions de la barre 40 qui a empêché la croissance épitaxiale de se réaliser audessus de son emplacement. Les peignes 11 et 13 formeront les deux grilles du transistor.

Au stade représenté par la figure 3, on retrouve une couche épitaxiale 14 de type n sur laquelle on a déposé un contact 15 de drain, par exemple par des dépôts successifs de nickel, de germanium et d'or. La barre 41 est cause de la faille 43 dans la couche 14. Les failles 42 et 43 permettront d'assurer la prise de contact sur les électrodes de grille.

La surface du contact de drain est déterminé par la puissance et le niveau de bruit minimum demandé au transistor. Son épaisseur peut être de quelques microns. Il peut être formé par dépôts successifs de nickel, de germanium et d'or afin de constituer un bon contact ohmique.

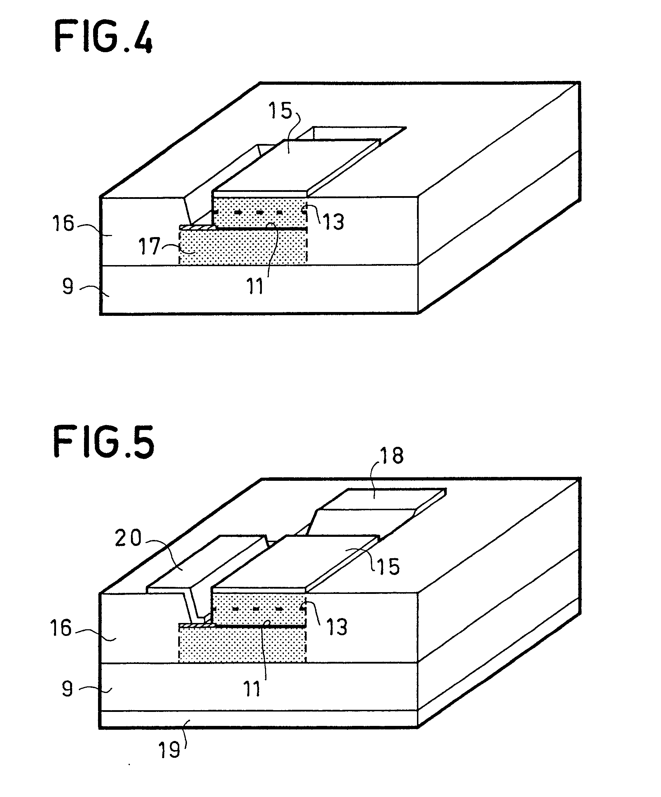

Au stade représenté par la figure 4, un bombardement de protons a rendu isolantes les parties de couches 10, 12 et 14 laissées découvertes par le contact 15 pour former la zone isolante 16 et un canal 17 allant de la couche 9 au contact de drain 15 et délimité par la surface de ce contact.

Au stade représenté par la figure 5, on a déposé des contacts de grilles 20 et 18 à la surface de la couche 16. Ces contacts pénètrent dans la couche 16 pour assurer une liaison électrique respectivement avec les grilles 11 et 13 à des endroits de ces grilles où les barres 40 et 41 avaient évité le recouvrement épitaxial. Ces contacts peuvent être réalisés par pulvérisation cathodique de nickel et germanium et d'or. De la même façon, on a déposé un contact 19 de source.

Il entre dans le cadre de l'invention de doubler les contacts de grilles afin de diminuer leur résistance ohmique. Les sorties de chaque grille se faisant par exemple symétriquement par rapport au contact de drain.

La description précédente n'a porté que sur la réalisation d'un seul transistor à partir d'un substrat par souci de simplification mais il entre dans le cadre de l'invention de réaliser une pluralité de transistors à partir d'un même substrat selon l'art connu.

Il entre également dans le cadre de l'invention de réaliser des transistors selon l'invention à partir d'un substrat en silicium.

Un transistor bigrille à structure verticale selon l'invention permet de disposer des avantages inhérents à ce type de transistor: haute fréquence d'utilisation, faible niveau de bruit.

**Revendications**

1. Transistor à effet de champ du type à grille enterrée et à canal vertical comprenant un substrat semi-conducteur monocristallin dopé (9) sur lequel sont épitaxiées successivement plusieurs couches dopées d'un même type de conductivité que ledit substrat; la base du substrat et le sommet de la dernière couche épitaxiée portant respectivement des contacts ohmiques de source (19) et de drain (15); ledit transistor comportant en outre des moyens conducteurs de commande; la conduction entre source et drain étant distribuée au sein desdites couches épitaxiées et empruntant un faisceau de zones collatérales isolées délimitées par lesdits moyens conducteurs de commande, caractérisé en ce que lesdits moyens conducteurs de commande sont constitués par deux systèmes de barreaux croisés (11, 13), chaque système étant réuni à un contact d'accès (20, 18).

2. Transistor selon la revendication 1, caractérisé en ce que les moyens de commande sont formés de barreaux possédant un cadre de liaison, les connexions aux contacts d'accès se faisant par au moins un côté du cadre.

3. Transistor selon l'une des revendications 1 ou 2, caractérisé en ce qu'on a rendu isolantes des parties du transistor situées en dehors du canal deconduction.

4. Transistor selon la revendication 3, caractérisé en ce que l'isolation desdites parties a été réalisée par un bombardement de protons.

**Patentansprüche**

1. Feldeffekttransistor vom Typ mit vergrabenem Gate und vertikalem Kanal, mit einem dotierten monokristallinen Halbleitersubstrat (9), auf dem nacheinander mehrere Schichten epitaktisch aufgebracht sind, welche mit demselben Leitfähigkeitstyp wie das Substrat dotiert sind; wobei das Basisteil des Substrats und die Oberseite der letzten epitaktischen Schicht jeweils ohmsche Kontakte für die Source-Elektrode (19) und die Drain-Elektrode (15) tragen; wobei der genannte Transistor ferner Steuer-Leitereinrichtungen umfasst; wobei die Leitung zwischen Source und Drain im Inneren der genannten epitaktischen Schichten verteilt ist und über ein Bündel von kolateralen isolierten Zonen erfolgt, welche durch die genannten Steuer-Leitereinrichtungen abgegrenzt sind, dadurch gekennzeichnet, dass die genannten Steuer-Leitereinrichtungen durch zwei Systeme von gekreuzten Stäben (11, 13) gebildet sind, wobei jedes System mit einem Zugangskontakt (20, 18) verbunden ist.

2. Transistor nach Anspruch 1, dadurch gekennzeichnet, dass die Steuereinrichtungen durch Stäbe gebildet sind, welche einen Verbindungsrahmen besitzen, wobei die Verbindungen mit den Zugangskontakten über wenigstens eine Seite des Rahmens erfolgen.

3. Transistor nach Anspruch 1 oder 2, dadurch gekennzeichnet, dass diejenigen Teile des Transistors, welche ausserhalb des Leitungskanals liegen, isolierend ausgebildet sind.

4. Transistor nach Anspruch 3, dadurch gekennzeichnet, dass die Isolierung der genannten Teile durch Protonenbeschuss hergestellt ist.

**Claims**

1. Field effect transistor of the type with buried gate and with a vertical channel comprising a monocrystalline doped semiconductor substrate (9) whereupon a plurality of layers are epitaxially deposited which are doped with the same conductivity type as said substrate; the base of the substrate and the top of the last epitaxially formed layer respectively carrying ohmic source (19) and drain (15) contacts; said transistor further comprising control conductor means; the conduction between the source and the drain being distributed within said epitaxial layers and occuring along a bundle of colateral insulated zones defined by said control conductor means, characterized in that said control conductor means are formed by two systems of crossed rods (11, 13), each system being connected to an access contact (20, 18).

2. Transistor according to claim 1, characterized in that the control means are formed of rods having a connection frame, the connections to the access contacts passing through at least one side of the frame.

3. Transistor according to claim 1 or 2, characterized in that those portions of the transistor located outside of the conduction channel have been made to be insulating.

4. Transistor according to claim 3, characterized in that the insulation of said portions has been obtained by proton bombing.

# FIG.1

# FIG.2

# FIG.3

# FIG.4

# FIG.5